# EUROPEAN PATENT APPLICATION

(11) **EP 1 569 165 A2**
(43) Date of publication of application: **31.08.2005**
(21) Application number: 05003661.5
(22) Date of filing: 21.02.2005
(51) Int. Cl.: G06K 19/077

(54) **Portable electronic device**

(30) Priority: 27.02.2004 JP 2004053963; 09.02.2005 JP 2005033381
(71) Applicant: KABUSHIKI KAISHA TOSHIBA, Tokyo 105-8001 (JP)
(72) Inventor: Ikeda, Hidetaka, Minato-ku, Tokyo 105-8001 (JP)
(74) Representative: Kramer - Barske - Schmidtchen

(57) **Abstract**

A contact type IC card (1) includes a plurality of holes (14) formed in the second portion of a core sheet providing a card body (8). The second portion is other than a first portion including a mounting portion that has an IC module (10) mounted therein. When the card body (8) is bent, the holes (14) serve as rigidity adjusting means for preventing bending stress from occurring in the IC module (10).

## Description

The present invention relates to a portable electronic device, such as an IC card with an LSI, an LSI-attached pamphlet, etc.

Noncontact IC cards, in which the contact of an IC module fitted in a hole defined between a card body and an antenna contained in the body is connected by a conductive elastic member, are well known as IC cards (see, for example, Jpn. Pat. Appln. KOKAI Publication No. 2001-175837). When a bending force is exerted on such an IC card from the outside, the conductive elastic member is deformed to prevent the connection state of the antenna and the IC module from being degraded by the deformation of the card. As a result, the connection state therebetween is maintained satisfactorily.

However, when a bending force is exerted on the IC card, it may be also exerted on the IC module. At worst, the LSI may be broken. In particular, in the above-described conventional IC card, the IC module is fitted in a hole formed in the card body by cutting. When a bending force is exerted on the card, the degree of bending will be higher at and around the hole than the other portion, therefore the portion at and around the hole will be much more deformed than the other portion. As a result, great bending stress will occur in the IC module.

It is an object of the invention to provide a portable electronic device, such as an IC card with an LSI, an LSI-attached pamphlet, etc., which is free from breakage of the LSI even when a bending force is exerted on the device.

To attain the object, in accordance with an aspect of the invention, there is provided a portable electronic device comprising: a first portion including an LSI-mounted portion; a second portion other than the first portion; and rigidity adjusting means for making the second portion have rigidity lower than the first portion, the rigidity being against a bending force exerted on the portable electronic device.

In the portable electronic device, when a bending force is exerted on the device from the outside, the second portion that has lower rigidity than the first portion including the LSI-mounted portion is greatly bent, thereby preventing the first portion from being greatly bent. Thus, even if the portable electronic device is bent, the LSI is protected from breakage.

In accordance with another aspect of the invention, there is provided a portable electronic device comprising: a front cover including a first portion, a second portion other than the first portion, and rigidity adjusting means for making the second portion have rigidity lower than the first portion, the first portion including an LSI-mounted portion, the rigidity being against a bending force exerted on the portable electronic device; a plurality of middle paper sheets; and a binding portion which bind the front cover and the middle paper sheets at one side.

In the above portable electronic device, when a bending force is exerted on the portable electronic device from the outside, the second portion that has lower rigidity than the first portion including the LSI-mounted portion is greatly bent, thereby preventing the first portion from being greatly bent. Thus, even if the portable electronic device is bent, the LSI is protected from breakage. Further, since the first portion with the LSI is located closer to the binding portion than the second portion, great bending stress is further prevented from occurring in the first portion.

This summary of the invention does not necessarily describe all necessary features so that the invention may also be a sub-combination of these described features.

The invention can be more fully understood from the following detailed description when taken in conjunction with the accompanying drawings, in which:
FIG. 1 is a schematic plan view illustrating the structure of a noncontact IC card according to a first embodiment of the invention;
FIG. 2 is a sectional view of the IC card of FIG. 1;
FIG. 3 is a view illustrating a bent state of the IC card of FIG. 1;
FIG. 4 is a plan view illustrating a modification of the IC card of FIG. 1;
FIG. 5 is a plan view illustrating another modification of the IC card of FIG. 1;
FIG. 6 is a schematic plan view illustrating the structure of a noncontact IC card according to a second embodiment of the invention;
FIG. 7 is a sectional view of the IC card of FIG. 6;
FIG. 8 is a view illustrating a bent state of the IC card of FIG. 6;
FIG. 9 is a schematic view illustrating the application of the IC card of FIG. 6 to a bankbook;
FIG. 10 is a view illustrating a bent state of the bankbook of FIG. 9;
FIG. 11 is a schematic view illustrating a modification of the bankbook in which slits are provided at different intervals;
FIG. 12 is a schematic view illustrating another modification of the bankbook in which slits of different widths are provided;
FIG. 13 is a schematic view illustrating yet another modification of the bankbook in which slits of different lengths are provided;
FIG. 14 is a schematic view illustrating another modification of the bankbook in which slits are provided around an LSI; and
FIG. 15 is a sectional view illustrating a modification of the body of the IC card in which the thickness is varied.

Embodiments of the invention will be described in detail with reference to the accompanying drawings.

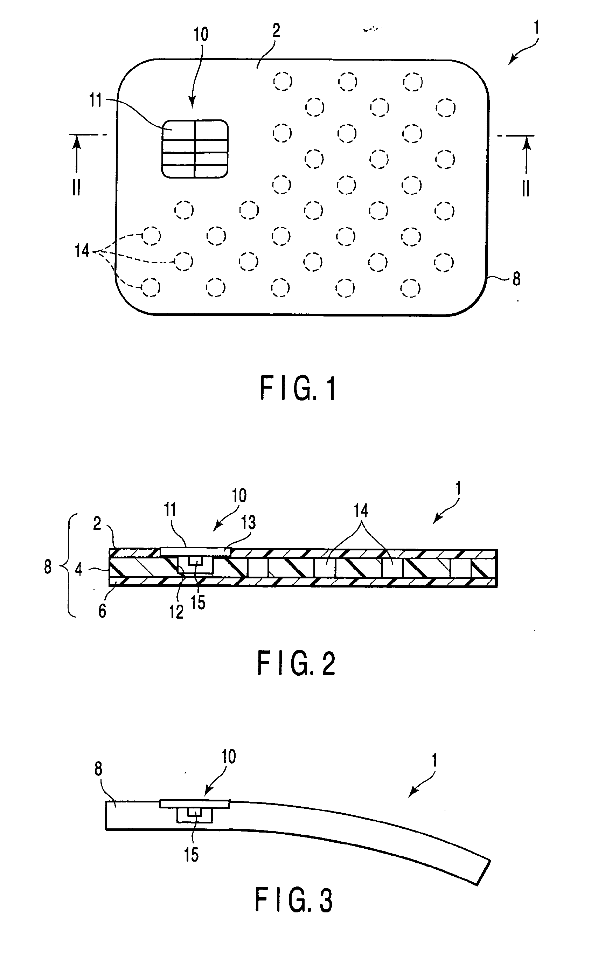

FIG. 1 is a schematic plan view illustrating the structure of a contact type IC card 1 (portable electronic device) (hereinafter referred to simply as "the IC card 1") according to a first embodiment of the invention. FIG. 2 is a sectional view taken along line II-II of FIG. 1, and FIG. 3 is a view useful in explaining the behavior of the IC card 1 assumed when bending stress occurs in the IC card 1. To clarify FIG. 3, the internal structure of the IC card 1 is not shown therein.

The IC card 1 comprises a card body 8 formed of a top sheet 2, core sheet 4 and bottom sheet 6 stacked on each other and having the same size, and also comprises an IC module 10. The sheets 2, 4 and 6 are attached to each other by thermal welding or by an adhesive. The four corners of the card body 8 are rounded.

A hollow portion 12 (mounting portion) for attaching the IC module 10 therein is formed in a predetermined portion of the card body 8. The hollow portion 12 is formed by cutting the card body 8 from the top sheet 2 side, so that it substantially extends through the core sheet 4 and has a bottom. The IC module 10 is fixed in the hollow portion 12 by an adhesive.

The IC module 10 comprises a base plate 13 having an external connection terminal 11 exposed at the surface of the card body 8, and an LSI 15 molded on the lower surface of the base plate 13. The LSI 15 is connected to the external connection terminal 11. The LSI 15 is connected to a card-processing machine (not shown) via the external connection terminal 11 for transmitting and receiving various data items.

The core sheet 4 has a plurality of holes 14 functioning as rigidity adjusting means. The holes 14 are provided in the portion (second portion) of the card body 8 other than the portion (first portion) around the hollow portion 12. In other words, the holes 14 are located at positions at which the rigidity of the second portion against the bending of the card body 8 is made lower than that of the first portion. More specifically, the holes 14 are located at positions at which when bending stress occurs in the IC card 1, almost no stress occurs in the IC module 10 received in the hollow portion 12.

Although in this embodiment, the holes 14 are formed only in the core sheet 4, the shape, the number, the depth, etc., of the holes 14 may be set arbitrarily. For example, the holes 14 may be formed in the top sheet 2 or bottom sheet 6 except for the peripheral portion of the IC module 10.

The above will be described in more detail. When the card body 8 is bent as shown in FIG. 3, bending stress occurs in the entire card body 8. At this time, the portion of the card body near the IC module 10, in which no holes 14 are formed, is not easily bent, while the portion in which the holes 14 are formed are greatly bent. Thus, when bending stress occurs in the IC card 1, the portion away from the IC module 10 is greatly bent, which prevents significant bending stress from occurring in the IC module 10, i.e., prevents the IC module 10 from being broken because of the bending of the LSI 15. It is a matter of course that the rigidity adjusting means sufficiently reduces the rigidity of the portion away from the hollow portion 12, compared to that of the portion near the hollow portion 12, in light of a reduction in the rigidity of the card body 8 due to the provision of the hollow portion 12.

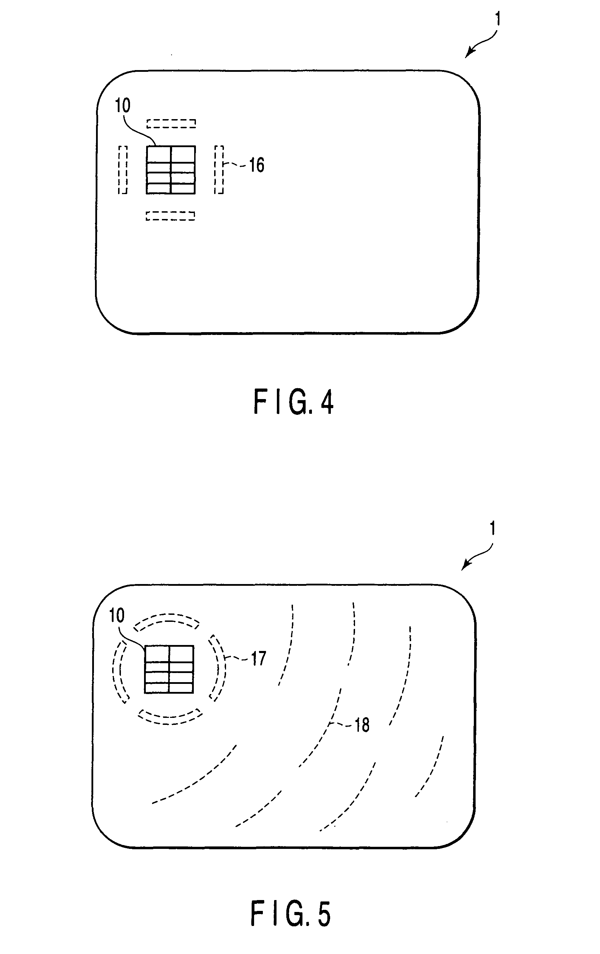

In the above-described first embodiment, the rigidity adjusting means is formed of the holes 14 provided in the core sheet 4. However, this means may be formed of slits 16 or 17 shown in FIG. 4 or 5, which are provided in the core sheet 4 around the IC module 10. As can be seen from FIG. 5, the slits may be curved to surround the IC module 10. Further, as shown in FIG. 5, slits 18 may be provided in the portion of the card body 8 remote from the IC module 10. The slits 16, 17 and 18 may be filled with a resin having an elasticity modulus lower than the core sheet 4.

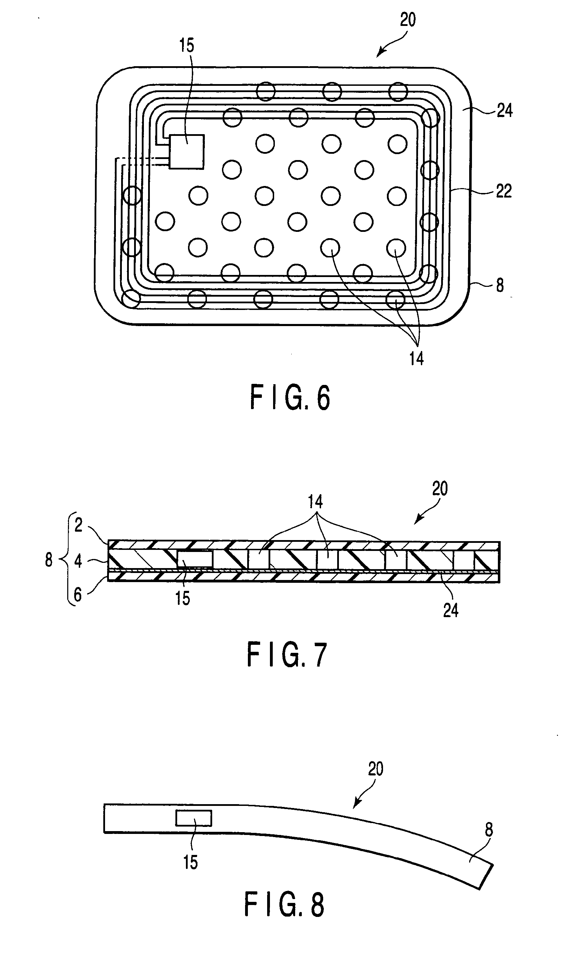

Referring then to FIGS. 6 to 8, a description will be given of a noncontact IC card 20 (portable electronic device) (hereinafter referred to simply as "the IC card 20") according to a second embodiment of the invention. FIG. 6 is a plan view illustrating the IC card 20 from which the top sheet 2 is removed. FIG. 7 is a sectional view of the IC card 20. FIG. 8 illustrates a state in which the IC card 20 is bent. For clarifying the structure of the IC card 20, in FIG. 6, a coil antenna 22 and LSI 15 provided on an antenna sheet 24 below the core sheet 4 are denoted by the solid lines. In the second embodiment, structural elements similar to those of the IC card 1 of the first embodiment are denoted by corresponding reference numerals, and no detailed description will be given thereof.

The IC card 20 has the antenna sheet 24 provided with the coil antenna 22 and the LSI 15. The LSI 15 is attached to the sheet 24 by flip chip. The antenna sheet 24 is adhered, using a hot-melt sheet, to the core sheet 4 provided with the holes 14. Also in the second embodiment, the mounting position of the LSI 15 on the antenna sheet 24, the positions, the number, shape, etc., of the holes 14 in the core sheet 4 are designed so as not to locate the holes 14 in the portion of the core sheet 4 that overlaps the LSI 15.

The holes 14 of the core sheet 4 are filled with a resin material that has a lower rigidity than the material of the core sheet 4. The top sheet 2 is adhered by a hot-melt adhesive to the surface of the core sheet 4 remote from the antenna sheet 24. Further, the bottom sheet 6 is adhered by a hot-melt adhesive to the antenna sheet 24. When, for example, the IC card 20 is positioned near the radio antenna of a card-processing machine (not shown), power is supplied to the LSI 15 via the coil antenna 22, whereby the IC card operates.

As described above, also in the second embodiment, the holes 14 in the core sheet 4 serve as rigidity adjusting means as in the first embodiment, which prevents being stress from occurring in the LSI 15 when the IC card 20 is bent as shown in FIG. 8, thereby protecting the LSI 15 from breakage. Note here that the resin material filled in the holes 14 has a lower rigidity than that of the material of the core sheet 4 defining the holes 14, therefore the resin material does not increase the rigidity more than required.

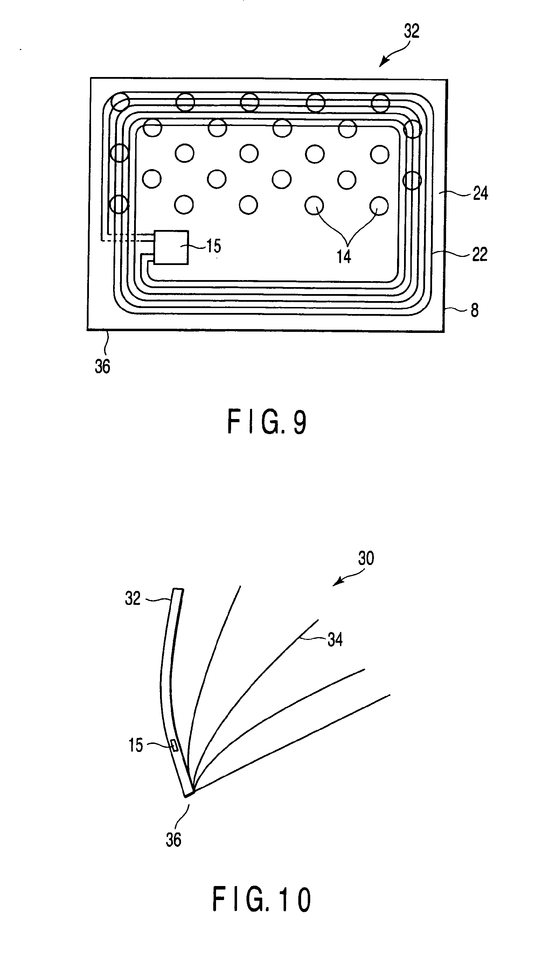

Referring to FIGS. 9 and 10, a description will be given of a modification of the noncontact IC card 20 of the second embodiment. FIG. 9 shows the internal structure of the front cover 32 of a bankbook as a portable electronic device of the invention, while FIG. 10 shows a state in which the bankbook 30 is bent. In this modification, structural elements similar to those of the noncontact IC card 20 of the second embodiment are denoted by corresponding reference numerals, and no detailed description will be given thereof.

The bankbook 30 comprises the front cover 32 having substantially the same structure as the noncontact IC card 20, a plurality of middle paper sheets 34, and a binding portion 36 located at one end of the bankbook and binding the cover 32 and sheets 34. In the bankbook 30, the antenna sheet 24 with the coil antenna 22 and the LSI 15 are used as a noncontact tag and embedded in the front cover 32. By virtue of this structure, when bending stress occurs in the entire bankbook 30, the LSI 15 is protected from breakage by the holes 14 that serves as rigidity adjusting means and greatly bends.

In particular, this modification is characterized in that the LSI 15 is located at a biased position near the binding portion 36 of the front cover 32 as shown in FIG. 9. Namely, the LSI 15 is provided at a position near the binding portion 36 of the front cover 32 that is hard to bend when the bankbook 30 is opened. As a result, when the bankbook 30 is bent, the bending force is not easily transmitted to the LSI 15, thereby more reliably protecting the LSI 15 from breakage.

Further, in the modification, no holes 14 are formed in the portion of the core sheet 4 close to the binding portion 36 so as to balance the rigidity of the front cover 32 when the front cover 32 is turned.

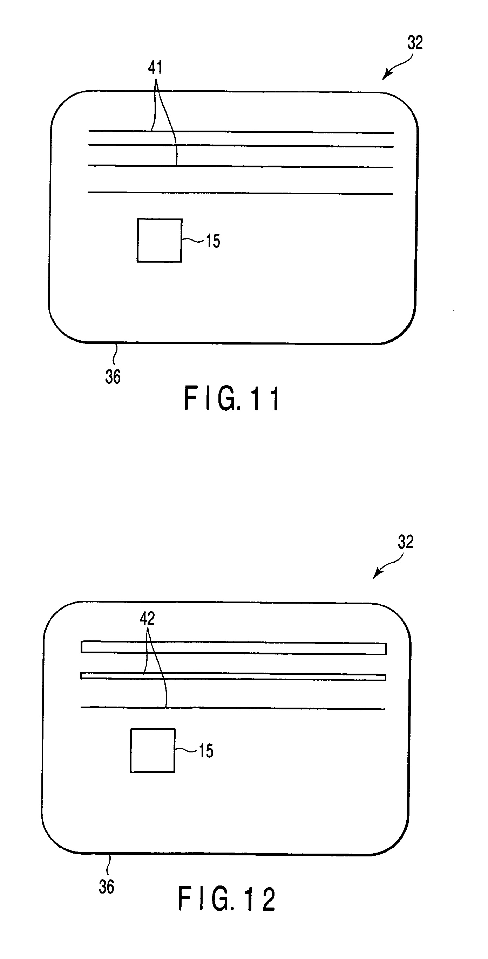

In the modification, the holes 14 are formed as rigidity adjusting means in the front cover 32 of the bankbook 30. However, a plurality of slits may be formed in the core sheet 4 of the front cover 32 as shown in FIGS. 11 to 14.

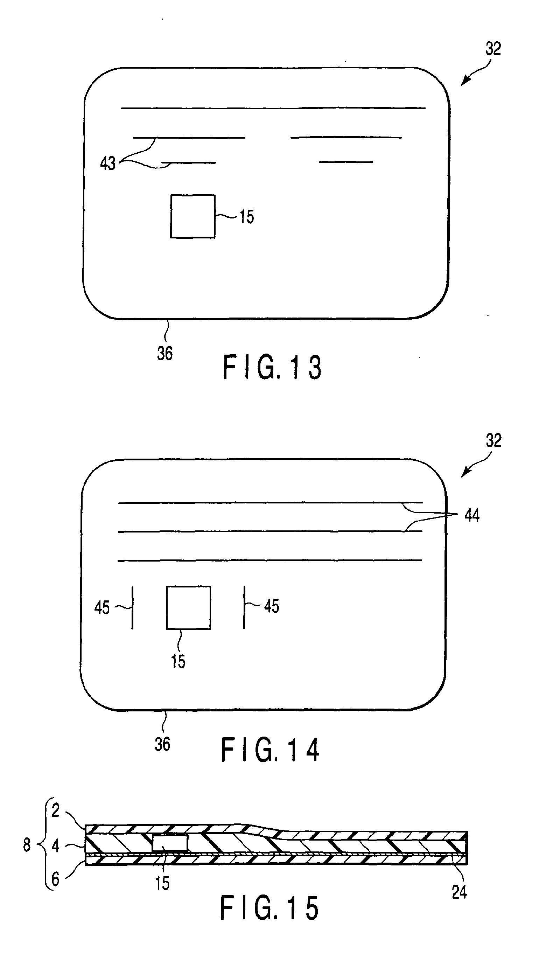

The bankbook shown in FIG. 11 is provided with a plurality of slits 41 are extended over the entire length of the front cover 32 and arranged at different intervals so that the further from the binding portion 36 the slit is located, the narrower the interval therebetween. The bankbook shown in FIG. 12 is provided with a plurality of slits 42 so that the further from the binding portion 36 the slit is located, the wider the width the slit has over the entire length of the front cover 32. The bankbook shown in FIG. 13 is provided with a plurality of slits 43 so that the further from the binding portion 36 the slit is located, the longer the slit. In any case, by virtue of the arrangement of the slits, the rigidity of the front cover 32 is made higher at and around the LSI 15 so that great bending stress does not occur in the LSI 15.

Furthermore, in the bankbook shown in FIG. 14, a plurality of slits 44 having the same width and length over the entire length of the front cover 32 are formed at regular intervals, and two slits 45 extending in the width direction are formed. The slits 44 reduce the rigidity of the portion of the front cover 32 other than the portion in which the LSI 15 is provided. In contrast, the two slits 45 are formed around the mounting portion of the LSI 15 so as not to transmit a bending force to the LSI 15. The slits 41 to 45 shown in FIGS. 11 to 14 may also be filled with a resin having an elasticity modulus lower than the core sheet 4.

As described above, in the invention, the second portion of the card body 8 other than the first portion of the body including the LSI-mounted portion is made to have a lower rigidity than the first portion. Accordingly, when a bending force is exerted on the card body 8, the second portion is greatly bent, which prevents bending stress from occurring in the LSI 15 located in the first portion, i.e., protects the LSI 15 from breakage.

The present invention is not limited to the above-described embodiments, but may be modified in various way without departing from the scope. Further, various inventions can be achieved by appropriately combining the structural elements disclosed in the embodiments. For example, some may be deleted from the structural elements disclosed in the embodiments. Furthermore, structural elements employed in different embodiments may be appropriately combined.

For instance, in the above-described embodiments, the holes 14 or slits serving as rigidity adjusting means for making the rigidity of the second portion of the card body 8 lower than that of the first portion are formed in the core sheet 4. However, a plurality of grooves with bottoms may be formed in the same region as the above. In addition, as shown in FIG. 15, the second portion of the core sheet 4 of the card body 8 may be made thinner than the first portion to reduce the rigidity. In particular, it is desirable that the second portion of the layer of the card body 8 that has the highest rigidity be made thinner than the first portion of the same layer to reduce the rigidity of the second portion.

Although in the embodiments, the card body 8 has three layers, it may have four or more layers. It is sufficient if the rigidity adjusting means, which is formed of, for example, the holes 14, is provided in at least one layer.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A portable electronic device, comprising:
a first portion including a LSI-mounted portion (12);
a second portion other than the first portion; and
rigidity adjusting means for making the second portion have rigidity lower than the first portion, the rigidity being against a bending force exerted on the portable electronic device.

2. The portable electronic device according to claim 1, wherein
the first portion is included in a card body (8) formed of a plurality of layers, and
the second portion is included in the card body (8).

3. The portable electronic device according to claim 1 or 2, further comprising
a front cover (32) including the first portion and the second portion other than the first portion,
a plurality of middle paper sheets (34), and
a binding portion (36) which binds the front cover and the middle paper sheets at one side.

4. The portable electronic device according to one of claims 1 to 3, **characterized in that** the rigidity adjusting means includes a plurality of holes (14) formed in the second portion.

5. The portable electronic device according to one of claims 1 to 4, **characterized in that** the rigidity adjusting means includes a plurality of slits (16-18, 41-45) formed in the second portion.

6. The portable electronic device according to claim 4 or 5, **characterized in that** the holes (14) and/or slits (16-18, 41-45) are filled with a material lower in rigidity than a material defining the holes and/or slits.

7. The portable electronic device according to one of claims 4 to 6, **characterized in that** the plurality of holes (14) and/or the plurality of slits (16-18, 41-45) are formed in at least one of the layers of the card body (8) and included in the second portion.

8. The portable electronic device according to one of claims 5 to 7, **characterized in that** at least some of the slits (41-45) extend over an entire length of the card body (8).

9. The portable electronic device according to one of claims 5 to 8, **characterized in that** at least some of the slits (16, 17, 45) surround the LSI-mounted portion.

10. The portable electronic device according to one of claims 2 to 8, **characterized in that** the second portion is thinner than the first portion, and is included in the rigidity adjusting means.

11. The portable electronic device according to claim 10, **characterized in that** the second portion and the first portion are included in one of the layers of the card body (8) which has highest rigidity.

12. The portable electronic device according to one of claims 3 to 11, **characterized in that** the front cover (32) is bound with the first portion located closer to the binding portion (36) than the second portion.

13. The portable electronic device according to one of claims 4 to 12, **characterized in that** the holes (14) and/or slits (41-44) are located further from the binding portion (36) than the LSI-mounted portion.
